# EUROPEAN PATENT SPECIFICATION

(11) **EP 4 524 966 B1**
(45) Date of publication and mention of the grant of the patent: **05.08.2026**
(21) Application number: 23818913.8
(22) Date of filing: 17.05.2023
(51) Int. Cl.: H03K 19/003, G11C 5/14, G11C 7/24, G11C 16/30, G11C 17/18

(54) **POWER SWITCH CIRCUIT, ELECTRICALLY PROGRAMMABLE FUSE MEMORY AND ELECTRONIC DEVICE**
LEISTUNGSSCHALTKREIS, ELEKTRISCH PROGRAMMIERBARER SICHERUNGSSPEICHER UND ELEKTRONISCHE VORRICHTUNG
CIRCUIT DE COMMUTATION DE PUISSANCE, MÉMOIRE À FUSIBLE ÉLECTRIQUEMENT PROGRAMMABLE ET DISPOSITIF ÉLECTRONIQUE

(30) Priority: 09.06.2022 CN 202210653790
(43) Date of publication of application: 19.03.2025
(73) Proprietor: Huawei Technologies Co., Ltd., Shenzhen, Guangdong 518129 (CN)
(72) Inventor: CAI, Jiangzheng, Shenzhen, Guangdong 518129 (CN); LIN, Dianpeng, Shenzhen, Guangdong 518129 (CN); BU, Mingen, Shenzhen, Guangdong 518129 (CN)
(74) Representative: Goddar, Heinz J.
(86) International application number: PCT/CN2023/094898
(87) International publication number: WO 2023/236748

(56) References cited:
- CN-A- 1 734 761
- CN-A- 109 961 821
- US-A- 6 140 863
- US-A1- 2007 081 282
- US-A1- 2009 310 266
- US-A1- 2020 083 704
- HARRIS DAVID: "High Speed CMOS VLSI Design Lecture 2: Logical Effort & Sizing", 4 November 1997 (1997-11-04), pages 1 - 11, XP093287447, Retrieved from the Internet <URL:https://pages.hmc.edu/harris/class/hal/lect2.pdf>
- GEIGER RANDALL L. ET AL: "VLSI design techniques for analog and digital circuits", 31 December 1990 (1990-12-31), pages 550 - 574, XP093287487, ISBN: 978-0-07-100728-3, Retrieved from the Internet <URL:https://class.ece.iastate.edu/ee508/GAS_book/chap7b.pdf>

## Description

### TECHNICAL FIELD

This application relates to the field of storage technologies, and in particular, to a power switch circuit, an electrically program fuse memory, and an electronic device.

### BACKGROUND

An electrically program fuse (Electrically Program Fuse, eFuse) memory (also referred to as a one-time programmable memory) is a memory that stores data based on electromigration and thermal fracture phenomena, and can permanently store programmed information.

The electrically program fuse memory includes a programming circuit and a memory cell array. The programming circuit is configured to output a programming voltage to a memory cell in the memory cell array, to program the memory cell, so as to store data in the memory cell. A power switch circuit includes a drive circuit and the programming circuit. The drive circuit is configured to output a control voltage to the programming circuit under control of a control signal. The programming circuit is configured to output the programming voltage to the memory cell in the memory cell array under control of the control voltage provided by the drive circuit, to program the memory cell.

The drive circuit and the programming circuit are usually designed with dual power supplies. To be specific, a power supply voltage is input to the drive circuit, and the programming voltage is input to the programming circuit. This dual-power supply design has strict requirements on a power-on sequence and a power-off sequence of the programming circuit and the drive circuit. During power-on, the drive circuit needs to be powered on before the programming circuit. During power-off, the programming circuit needs to be powered off before the drive circuit. Power-on of the drive circuit means that the power supply voltage is input to the drive circuit, and power-off of the drive circuit means that the drive circuit loses the input power supply voltage. Power-on of the programming circuit means that the programming voltage is input to the programming circuit, and power-off of the programming circuit means that the input programming voltage is lost.

Otherwise, during power-on, if the programming circuit is powered on before the drive circuit, or during power-off, if the drive circuit is powered off before the programming circuit, an internal component of the drive circuit generates a floating (floating) signal, and a coupling voltage is generated due to capacitive coupling effect. The drive circuit controls, via the coupling voltage, the programming circuit to output the programming voltage to the memory cell array, resulting in incorrect programming of the memory cell array.

US 2009/310266 A1 discloses an eFuse circuit has a first detector for determining whether an electrostatic discharge (ESD) event occurs at a circuit pad of an integrated circuit and provides an ESD trigger signal in response thereto. A second detector detects a presence of a first power supply voltage and provides a power on signal indicating the presence of the first power supply voltage. A fuse is permitted to be programmable when no detection of the ESD event occurs and at the same time a presence of the power on signal is detected. The fuse is not permitted to be programmed when an ESD event is detected or when there is an absence of the power on signal. An array of fuses is thereby protected from inadvertent programming from an ESD event or powering up an integrated circuit.

### SUMMARY

Embodiments of this application provide a power switch circuit, an electrically program fuse memory, and an electronic device, to avoid capacitive coupling effect in the electrically program fuse memory.

To achieve the foregoing objectives, the invention provides a power supply switch circuit of claim 1, an electrically program fuse memory of claim 12, and an electronic device of claim 13. Further embodiments are disclosed in the dependent claims. The following technical solutions are used in embodiments of this application wherein embodiments of the following description not covered by the claims shall be considered as examples helpful for understanding the invention.

According to a first aspect, a power switch circuit of claim 1 is provided. The power switch circuit is configured to be coupled to a memory cell in a memory cell array, to output a programming voltage to the memory cell. The programming voltage is used to program the memory cell. The power switch circuit includes a drive circuit, a programming circuit, and a protection circuit. The drive circuit is powered by a power supply voltage, and the programming circuit is powered by the programming voltage. The drive circuit includes a control voltage circuit and a first transistor. The protection circuit includes a comparator circuit and a second transistor. An output end of the control voltage circuit is coupled to a gate of the first transistor. A first electrode of the first transistor is used as an output end of the drive circuit and is coupled to a control end of the programming circuit at a coupling point. A first electrode of the second transistor is coupled to the coupling point. A control end of the comparator circuit receives the power supply voltage and compares the power supply voltage with a preset value . An output end of the comparator circuit is coupled to a gate of the second transistor. An output end of the programming circuit is coupled to the memory cell, and is configured to output the programming voltage. A drive capability of the second transistor is greater than a drive capability of the first transistor. The protection circuit, the drive circuit and the programming circuit are such that when the power supply voltage is less that the preset-value, a low voltage insufficient to program the memory cell is output by the programming circuit; the drive circuit further comprises a third transistor, a first electrode of the third transistor is coupled to a second electrode of the first transistor, a second electrode of the third transistor is grounded, a gate of the third transistor is configured to input connected to the programming voltage, and the programming voltage is used to turn on the third transistor, wherein the third transistor is configured to ensure that the programming circuit always output a low voltage when there is no programming voltage.

It is ensured that the third transistor is turned on only when the programming voltage is powered on, so that the second electrode of the first transistor is grounded.

In this embodiment of this application, when the power supply voltage is powered off before the programming voltage, or when the power supply voltage is powered on after the programming voltage, the control voltage circuit of the drive circuit generates a coupling voltage. The generated coupling voltage is transmitted to the programming circuit, causing incorrect programming of the programming circuit. In this embodiment of this application, the coupling voltage generated by the control voltage circuit is isolated via the first transistor. When the coupling voltage is less than a threshold voltage of the first transistor, the first transistor is not turned on. When the coupling voltage is higher than the threshold voltage of the first transistor, the first transistor outputs a first voltage to the coupling point via the first electrode, and the first voltage controls the programming circuit to output the programming voltage to the memory cell. In this case, that the second transistor is used for processing is specifically: The second transistor receives the power supply voltage via the comparator circuit, and determines a value of the power supply voltage. When the power supply voltage is less than a specific value, the comparator circuit controls the second transistor to be turned on, so that the second voltage is input via the first electrode of the second transistor. The second voltage is used to control the programming circuit not to perform programming. When both the first transistor and the second transistor are turned on, because the drive capability of the second transistor is greater than the drive capability of the first transistor, the second voltage output by the first electrode of the second transistor plays a decisive role at the coupling point, and the programming circuit is controlled not to output the programming circuit to the memory cell. In this embodiment of this application, the foregoing setting is used to resolve incorrect programming of the programming circuit because the power supply voltage is powered off before the programming voltage or the power supply voltage is powered on after the programming voltage, and also resolve a problem that a power-on sequence and a power-off sequence of the programming voltage and the power supply voltage are limited.

In a possible implementation, the control voltage circuit is configured to: receive the power supply voltage; and when the power supply voltage is greater than or equal to a preset value, input a control signal, generate a control voltage based on the control signal, and output the control voltage to the gate of the first transistor. The first transistor is further configured to: when the first transistor is turned on because the gate receives the control voltage, output the first voltage to the control end of the programming circuit via the first electrode of the first transistor.

In this embodiment of this application, when the power supply voltage reaches the preset value and programming starts, the control signal is input to the control voltage circuit, the control voltage is generated based on the input control signal, and the generated control voltage is output to the gate of the first transistor, to turn on the first transistor. After the first transistor is turned on, the programming circuit outputs the programming voltage to the memory cell. In a programming phase, the programming circuit can be controlled to perform programming or not by adjusting different input control signals. This operation is simple and convenient, and has high stability.

In a possible implementation, the comparator circuit is further configured to: when the power supply voltage is greater than or equal to the preset value, control the second transistor to be turned off.

In the invention, the comparator circuit is used to determine whether the power supply voltage reaches the preset value. When the power supply voltage does not reach the preset value, there is a risk of incorrect programming because the first transistor is turned on via the coupling voltage. In this case, the comparator circuit controls the second transistor to continuously output the second voltage, and the programming circuit maintains, via the second voltage, a voltage that is insufficient for programming the memory cell. When the power supply voltage reaches the preset value, impact of capacitive coupling effect decreases, and the coupling voltage decreases or disappears. In this case, to implement subsequent normal programming, the second transistor no longer needs to output the second voltage. When determining that the power supply voltage reaches the preset value, the comparator circuit outputs a third voltage to the second transistor, and the second transistor is controlled to be turned off via the third voltage.

In some possible implementations, the comparator circuit includes a sixth transistor, a seventh transistor, and a Schmitt trigger. A gate of the sixth transistor is used as an input end of the comparator circuit and is configured to input the power supply voltage. A first electrode of the sixth transistor and a first electrode of the seventh transistor are jointly coupled to an input end of the Schmitt trigger. A second electrode of the sixth transistor is grounded. An output end of the Schmitt trigger is used as the output end of the comparator circuit and is coupled to the gate of the second transistor.

In this embodiment of this application, the comparator circuit includes the sixth transistor, the seventh transistor, and the Schmitt trigger. The gate of the sixth transistor is connected to the power supply voltage. The first electrode of the sixth transistor and the first electrode of the seventh transistor are jointly coupled to the input end of the Schmitt trigger. The second electrode of the sixth transistor is grounded. A second electrode of the seventh transistor is configured to input a fifth voltage. When the power supply voltage is less than the preset value, the first electrode of the seventh transistor is configured to output the fifth voltage to the input end of the Schmitt trigger. The fifth voltage is used to control, via the Schmitt trigger, the first electrode of the second transistor to output the second voltage. When the power supply voltage is greater than or equal to the preset value, the sixth transistor is turned on because the gate receives the power supply voltage. The first electrode of the sixth transistor is configured to output a sixth voltage to the input end of the Schmitt trigger. The sixth voltage is used to control, via the Schmitt trigger, the second transistor to be turned off. The fifth voltage and the sixth voltage are voltages representing opposite levels, and the third voltage and the fourth voltage are voltages representing opposite levels.

In some possible implementations, the comparator circuit further includes an eighth transistor. A gate of the eighth transistor is connected to the programming voltage. The programming voltage is used to control the eighth transistor to be turned on. A first electrode of the eighth transistor is coupled to the second electrode of the sixth transistor, and a second electrode of the eighth transistor is grounded.

In this embodiment of this application, the programming voltage is input to the gate of the eighth transistor, and the programming voltage controls the eighth transistor to be turned on. When the programming voltage is not powered on, regardless of whether the sixth transistor is turned on, because the eighth transistor is not turned on, the sixth transistor cannot provide the third voltage to the Schmitt trigger. Therefore, it is ensured that when the programming voltage is not powered on, the programming circuit always outputs, to the memory cell, a low voltage that is insufficient to program the memory cell.

In some possible implementations, the comparator circuit further includes a ninth transistor. A first electrode of the ninth transistor is coupled to the second electrode of the eighth transistor, and a second electrode of the ninth transistor is grounded. A gate of the ninth transistor and the gate of the sixth transistor are connected in parallel, and used as the input end of the comparator circuit to input the power supply voltage. In this embodiment of this application, the ninth transistor is disposed to divide a voltage input to the gate of the sixth transistor, to increase a threshold for turning on the sixth transistor via the power supply voltage.

In some possible implementations, the comparator circuit further includes a first resistor. An input end of the first resistor is configured to is connected to the power supply voltage. An output end of the first resistor is coupled to the gate of the sixth transistor, and is configured to output the power supply voltage. In this embodiment of this application, the first resistor is disposed to limit an input current, to protect the sixth transistor and the ninth transistor, and avoid damage to the sixth transistor and the ninth transistor caused by an excessively large current.

In some possible implementations, the programming circuit includes a fourth transistor and a programming power switch circuit. A control end of the programming power switch circuit is used as the control end of the programming circuit, and is coupled to the coupling point together with the first electrode of the first transistor, the first electrode of the second transistor, and a first electrode of the fourth transistor. An output end of the programming power switch circuit is used as the output end of the programming circuit, and is configured to be coupled to the memory cell, to output the programming voltage to the memory cell. A drive capability of the fourth transistor is equal to or less than the drive capability of the first transistor.

In this embodiment of this application, the first electrode of the fourth transistor continuously outputs a seventh voltage to the programming power switch circuit, and the programming power switch circuit is controlled, via the seventh voltage, to output a voltage that is insufficient to program the memory cell. When the first transistor is turned on, the first electrode of the first transistor pulls a current output by the first electrode of the fourth transistor, so that the first electrode of the first transistor outputs the first voltage to the programming power switch circuit, and the programming power switch circuit is controlled, via the first voltage, to output the programming voltage to the memory cell.

In some possible implementations, the programming power switch circuit includes an odd quantity of inverter components, and a single inverter component includes an NMOS transistor and a PMOS transistor. A gate of the PMOS transistor of the inverter component and a gate of the NMOS transistor of the inverter component are coupled and then used as a control end of the inverter component. A drain of the PMOS transistor of the inverter component and a drain of the NMOS transistor of the inverter component are coupled and then used as an output end of the inverter component. A source of the PMOS transistor of the inverter component is connected to the programming voltage. When the programming power switch circuit includes a single inverter component, a control end of the single inverter component is used as the control end of the programming power switch circuit, and is coupled to the coupling point together with the first electrode of the first transistor, the first electrode of the second transistor, and the first electrode of the fourth transistor; and an output end of the single inverter component is used as the output end of the programming power switch circuit, and is configured to be coupled to the memory cell, to output the programming voltage to the memory cell. When the programming power switch circuit includes a plurality of inverter components, an output end of a previous-stage inverter component is coupled to a control end of a next-stage inverter component; a control end of a first-stage inverter component is used as the control end of the programming power switch circuit, and is coupled to the coupling point together with the first electrode of the first transistor, the first electrode of the second transistor, and the first electrode of the fourth transistor; and an output end of a last-stage inverter component is used as the output end of the programming power switch circuit, and is configured to be coupled to the memory cell, to output the programming voltage to the memory cell.

In this embodiment of this application, the programming power switch circuit includes the odd quantity of inverter components. When a high voltage is input to the control end of the programming power switch circuit, the programming power switch circuit outputs a low voltage to the memory cell, so that the memory cell is not programmed. When a low voltage is input to the control end of the programming power switch circuit, the programming power switch circuit outputs the programming voltage to the memory cell, to program the memory cell. The odd quantity of inverter components play a same role in control logic. However, the plurality of inverter components are disposed, so that a specific delay may be increased. An output is corrected in real time based on the delay, to avoid a case in which a reversal speed is excessively high, and the output is not steady when the single inverter component performs output and when the output of the inverter component is repeatedly reversed.

In some possible implementations, the second electrode of the fourth transistor is connected to the programming voltage.

In this embodiment of this application, the second electrode of the fourth transistor is configured to output a high voltage, to control the programming power switch circuit to output a low voltage to the memory cell. The high voltage may be provided by an additionally disposed voltage component, or may be provided by the programming voltage. Providing a high level by the programming voltage can reduce setting of additional power supply devices, and can ensure power-on synchronization between the high voltage and the programming voltage, thereby improving system stability.

In some possible implementations, the control voltage circuit includes a first inverter, a NAND gate, and an inverter group, and the inverter group includes an odd quantity of second inverters. An input end of the first inverter is configured to receive a first control signal, and an output end of the first inverter is coupled to a first input end of the NAND gate. A second input end of the NAND gate is configured to receive a second control signal. An output end of the NAND gate is connected to an input end of the inverter group. An output end of the inverter group is used as the output end of the control voltage circuit and is coupled to the gate of the first transistor, and is configured to output the control voltage.

In this embodiment of this application, when the power supply voltage reaches the preset value and programming starts, the control signal is input to the control voltage circuit, the control voltage is generated based on the input control signal, and the generated control voltage is output to the gate of the first transistor, to turn on the first transistor. After the first transistor is turned on, the programming circuit outputs the programming voltage to the memory cell. In the programming phase, the programming circuit can be controlled to perform programming or not by adjusting different input control signals. This operation is simple and convenient, and has high stability. The control signal includes the first control signal and the second control signal. The first control signal, the second control signal, the first inverter, the NAND gate, and the inverter group work together to control whether the control voltage circuit outputs the control voltage to the gate of the first transistor. In this way, programming is controlled.

In some possible implementations, the drive circuit further includes a fifth transistor. A gate of the fifth transistor is connected in parallel to the gate of the first transistor, and is configured to be coupled to the output end of the control voltage circuit. A first electrode of the fifth transistor is coupled to the second electrode of the third transistor, and the second electrode of the fifth transistor is grounded.

In this embodiment of this application, the fifth transistor is used to divide a voltage of the first transistor, to improve an isolation capability of the first transistor from the coupling voltage.

In some possible implementations, a second electrode of the second transistor is connected to the programming voltage.

In this embodiment of this application, the second electrode of the second transistor outputs a high voltage to the programming circuit, to control the programming power switch circuit to output, to the memory cell, a low voltage that is insufficient to program the memory cell. The high voltage may be provided by an additionally disposed voltage component, or may be provided by the programming voltage. Providing a high level by the programming voltage can reduce setting of additional power supply devices, and can ensure power-on synchronization between the high voltage and the programming voltage, thereby improving system stability.

According to a second aspect, an electrically program fuse memory as defined by claim 12 is provided.

According to a third aspect, an electronic device as defined in claim 13 is provided.

For technical effect of the second aspect and the third aspect, refer to the descriptions of the first aspect. Details are not described again.

### BRIEF DESCRIPTION OF DRAWINGS

FIG. 1 is a diagram of a structure of an electrically program fuse memory according to an embodiment of this application;
FIG. 2 is a diagram of a structure of another electrically program fuse memory according to an embodiment of this application;
FIG. 3 is a schematic of a structure of a power switch circuit of an example not covered by the claims;
FIG. 4 is a schematic of a structure of a power switch circuit according to an embodiment of this application;
FIG. 5 is a schematic of a structure of a programming circuit according to an embodiment of this application;
FIG. 6 is a diagram of a structure of an electrically program fuse memory according to an embodiment of this application;
FIG. 7 is a diagram of a structure of a Schmitt trigger according to an embodiment of this application;
FIG. 8 is is a diagram of a power-on phase and a programming phase when the first transistor 112 is disposed in the drive circuit 110;
FIG. 9 is another diagram of comparison between voltage changes of parts in a power-on phase and a programming phase according to an embodiment of this application;
FIG. 10 is a diagram of a power-off phase when the first transistor 112 is disposed in the drive circuit 110;
FIG. 11 is another diagram of comparison between voltage changes of parts in a power-off phase according to an embodiment of this application; and
FIG. 12 is a diagram of a structure of an electronic device according to an embodiment of this application.

### DESCRIPTION OF EMBODIMENTS

It should be noted that in embodiments of this application, terms such as "first" and "second" are merely used to distinguish between features of a same type, and cannot be understood as an indication of relative importance, a quantity, a sequence, or the like.

In embodiments of this application, the word like "example" or "for example" is used to represent giving an example, an illustration, or a description. Any embodiment or design scheme described as an "example" or "for example" in this application should not be explained as being more preferred or having more advantages than another embodiment or design scheme. To be precise, use of the word like "example" or "for example" is intended to present a relative concept in a specific manner.

Terms "coupling" and "connection" in embodiments of this application should be understood in a broad sense. For example, the term may refer to a physical direct connection, or may refer to an indirect connection implemented through an electronic component, for example, a connection implemented through a resistor, an inductor, a capacitor, or another electronic component.

First, some basic concepts in embodiments of this application are explained and described.

A drive capability refers to a load capacity. An influencing factor is a load capacity of a next-stage device, and the drive capability is mainly represented by a voltage requirement, a current requirement, and the like. The voltage requirement is used as an example. If a voltage required for normal operation of the next-stage device is 5 V, a drive capability of a current-stage device refers to that a voltage output by the current-stage device meets the following requirement: The voltage remains stable or does not decrease to less than 5 V due to a load of the next-stage device after the current-stage device is connected to the next-stage device. The current requirement is used as an example. If a current required for normal operation of the next-stage device is 5 A, the drive capability of the current-stage device refers to that a current output by the current-stage device meets the following requirement: The current remains stable or does not decrease to less than 5 A due to the load of the next-stage device after the current-stage device is connected to the next-stage device. A drive capability of an electronic component is optionally adjustable based on a property, a parameter, and the like of the component.

An electrically program fuse (Electrically Program Fuse, eFuse) memory (also referred to as a one-time programmable memory) is a memory that stores data based on electromigration and thermal fracture phenomena, and can permanently store programmed information. The eFuse originates from a discovery: Compared with an older laser fuse technology, an electron migration (Electron Migration, EM) characteristic may be used to generate a smaller fuse structure, that is, an EM fuse. The EM fuse can be programmed on a chip, whether in a wafer probing phase or in a packaging phase. Only a 10 mA direct current pulse lasting 200 microseconds provided by an on-chip voltage of an I/O circuit is sufficient to program a single EM fuse. Different from a static random access memory (Static Random Access Memory, SRAM) array used by most field programmable gate arrays (Field Programmable Gate Arrays, FPGAs), the eFuse memory has only one EM fuse that can be programmed at a time. This is a reason why a configuration capability of the method is limited. However, when used in combination with an increasingly mature built-in self-test (Built-in Self-Test, BIST) engine, these EM fuses become powerful tools that can reduce costs of testing and self-repairing, which is required for a complex chip design.

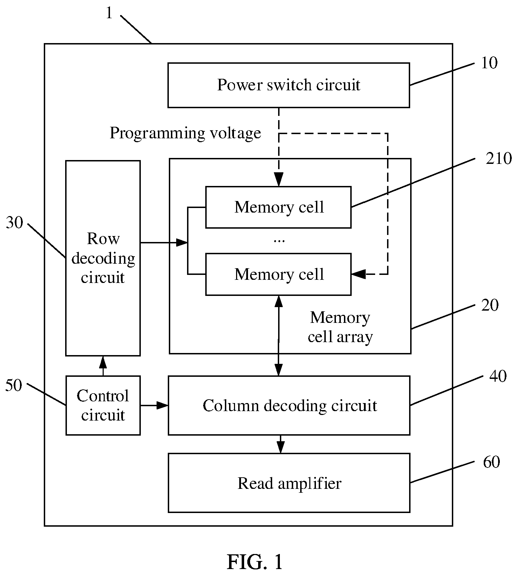

As shown in FIG. 1, an embodiment of this application provides an electrically program fuse memory 1, including a power switch circuit 10, a memory cell array 20, a row decoding circuit 30, a column decoding circuit 40, a control circuit 50, and a read amplifier 60. The power switch circuit 10 is configured to provide a programming voltage to the memory cell array 20, and program a memory cell 210 in the memory cell array 20 via the programming voltage, to store data in the memory cell 210. The control circuit 50 is configured to control the row decoding circuit 30 and the column decoding circuit 40 to decode a physical address in a read/write command, to determine the corresponding memory cell 210. The read amplifier 60 is configured to read the data stored in the memory cell 210.

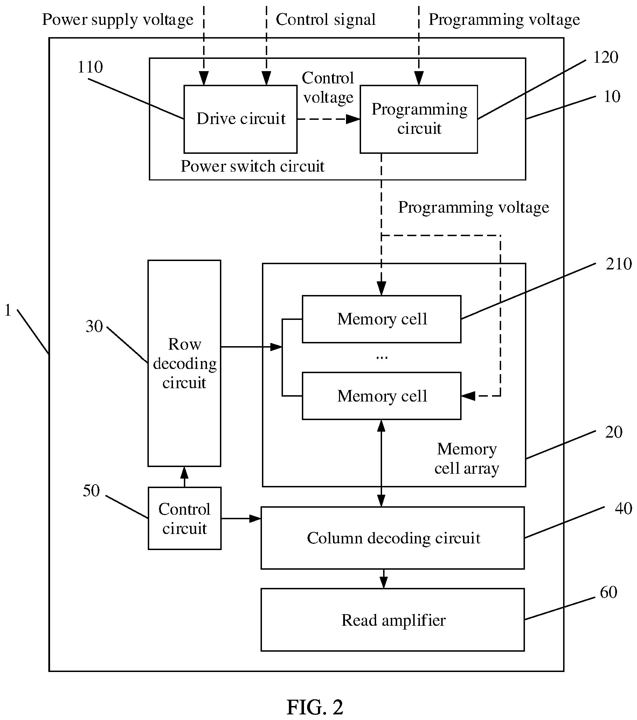

As shown in FIG. 2, the power switch circuit 10 includes a drive circuit 110 and a programming circuit 120. The programming circuit 120 is configured to receive a programming voltage. The programming voltage is output to the memory cell 210, to program the memory cell 210. The drive circuit 110 is configured to receive a control signal and a power supply voltage, and generate a control voltage based on the control signal. The control voltage is used to control the programming circuit 120 to output the programming voltage to the memory cell 210 in the memory cell array 20. The power supply voltage is used to supply power to the drive circuit 110.

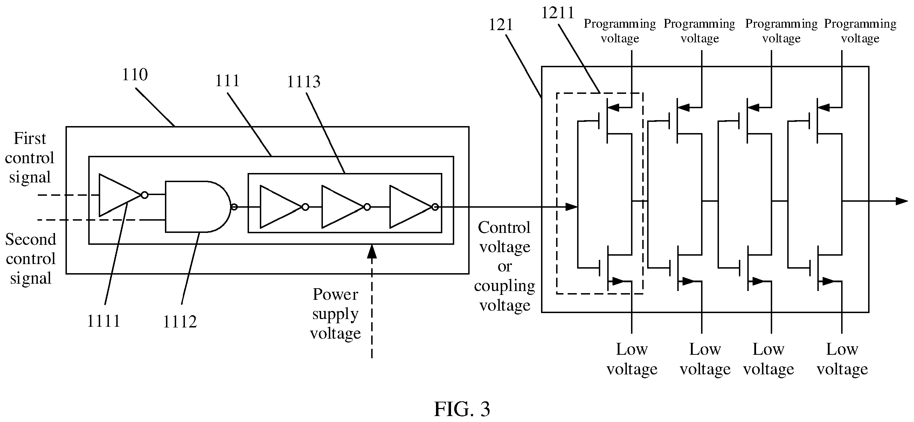

For example, the control signal includes a first control signal and a second control signal. As shown in FIG. 3, the drive circuit 110 not covered by the claims includes a control voltage circuit 111. The control voltage circuit 111 includes a first inverter 1111, a NAND gate 1112, and an inverter group 1113. The inverter group 1113 includes an odd quantity of second inverters. When there are a plurality of second inverters, the plurality of second inverters are connected in series. An input end of the first inverter 1111 is configured to receive the first control signal, and an output end of the first inverter 1111 is coupled to a first input end of the NAND gate 1112. A second input end of the NAND gate 1112 is configured to receive the second control signal, an output end of the NAND gate 1112 is connected to an input end of the inverter group 1113, and an output end of the inverter group 1113 is configured to output a control voltage to the programming circuit 120. When the first control signal is a low-voltage signal and the second control signal is a high-voltage signal, the control voltage circuit 111 outputs the control voltage via the output end of the inverter group 1113, and in this case, the control voltage is a high voltage. When the first control signal and the second control signal are in another case, the control voltage circuit 111 outputs a low voltage via the output end of the inverter group 1113.

As shown in FIG. 3, the programming circuit 120 includes a programming power switch circuit 121. The programming power switch circuit 121 includes an even quantity of cascaded inverter components 1211. A control end of a first-stage inverter component 1211 is used as a control end of the programming circuit 120 to receive the control voltage, an output end of a last-stage inverter component 1211 is used as an output end of the programming circuit 120 to output the programming voltage or a low voltage, and an output end of a previous-stage inverter component 1211 is coupled to a control end of a next-stage inverter component 1211. For a single inverter component 1211, a first electrode of the inverter component 1211 is configured to input the programming voltage, and a second electrode of the inverter component 1211 is configured to input the low voltage. The inverter component 1211 is configured to: when a high voltage is input to the control end of the inverter component 1211, output a low voltage via the output end of the inverter component 1211; or when a low voltage is input to the control end of the inverter component 1211, output a programming voltage via the output end of the inverter component 1211. The control voltage circuit 111 outputs a high-voltage control voltage to the programming circuit 120. After receiving the high-voltage control voltage, the programming circuit 120 outputs a high-voltage programming voltage to the memory cell 210 via the even quantity of inverter component 1211.

The even quantity of cascaded inverter components 1211 are logically equivalent to no inverter component 1211 in terms of an output signal. However, the even quantity of inverter components 1211 may form an oscillator, so that an output voltage signal reaches a steady state, to avoid voltage contention. However, in FIG. 3 of this application, the inverter component 1211 has a function of outputting the high-voltage programming voltage when receiving the high-voltage control voltage output by the control voltage circuit 111. For an odd quantity of inverter components 1211, disposing the single inverter component 1211 and disposing the plurality of odd quantity of inverter components 1211 are also logically consistent in terms of the output signal, but a delay may be increased for the plurality of inverter components 1211. An output is corrected in real time based on the delay, to avoid a case in which a reversal speed is excessively high, and the output is not steady when the single inverter component 1211 performs output and when the output of the inverter component 1211 is repeatedly reversed.

For example, an operation and running process of the electrically program fuse memory 1 based on FIG. 2 and FIG. 3 may be divided into the following three phases: a power-on phase, a programming phase, and a power-off phase. In the power-on phase, there are two power-on processes: drive power-on and programming power-on. A process in which a power supply voltage is input to the drive circuit 110 is drive power-on, and a process in which a programming voltage is input to the programming circuit 120 is programming power-on. In the programming phase, both drive power-on and programming power-on are completed, and the power supply voltage reaches a preset value. The drive circuit 110 starts to receive the control signal, generates the control voltage based on the control signal, and controls, via the control voltage, the programming circuit to output the programming voltage to the memory cell 210 in the memory cell array 20, to program the memory cell 210. The preset value is a minimum voltage value required by the power supply voltage to meet normal operation of the drive circuit 110. After programming ends, the power-off phase starts. In the power-off phase, there are also two power-off processes: drive power-off and programming power-off. A process in which the drive circuit 110 loses the input power supply voltage is drive power-off. A process in which the programming circuit 120 loses the programming voltage is programming power-off.

However, in a process of programming the memory cell 210 via the electrically program fuse memory 1 including the power switch circuit 10 in FIG. 2 and FIG. 3, there are strict requirements on a power-on sequence and a power-off sequence of the drive circuit 110 and the programming circuit 120. In the power-on phase before programming starts, the drive circuit 110 needs to be powered on before the programming circuit 120, that is, drive power-on is performed before programming power-on. In the power-off phase after programming ends, the drive circuit 110 needs to be powered off after the programming circuit 120, that is, drive power-off is performed after programming power-off. Otherwise, if the programming circuit 120 is powered on before the drive circuit 110 in the power-on phase, or if the drive circuit 110 is powered off before the programming circuit 120 in the power-off phase, when drive power-on is performed, an internal component of the drive circuit 110 generates a floating (floating) signal as the power supply voltage increases, and a coupling voltage is generated in the drive circuit 110 and is output to the programming circuit 120 due to capacitive coupling effect. Under control of the coupling voltage, the programming circuit 120 outputs the programming voltage to the memory cell array 20, resulting in incorrect programming of the memory cell 210 in the memory cell array 20.

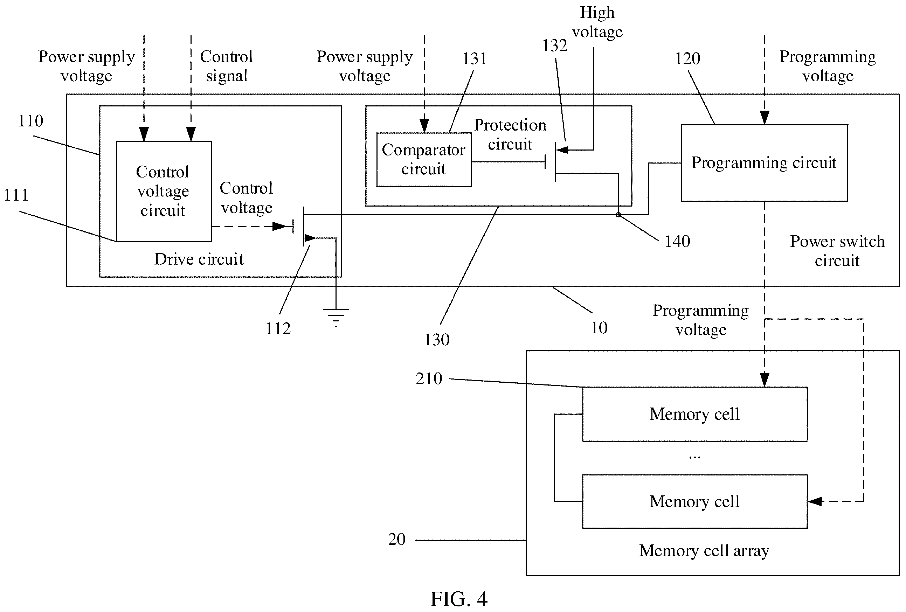

Therefore, as shown in FIG. 4, an embodiment of this application provides an electrically program fuse memory 1, including a power switch circuit 10 and a memory cell array 20. The power switch circuit 10 includes a drive circuit 110, a programming circuit 120, and a protection circuit 130. The protection circuit 130 is coupled at a coupling point 140 between an output end of the drive circuit 110 and a control end of the programming circuit 120. An input end of the programming circuit 120 is configured to input a programming voltage. An output end of the programming circuit 120 is coupled to a memory cell 210 in the memory cell array 20, and is configured to output the programming voltage. The drive circuit 110 includes a control voltage circuit 111 and a first transistor 112. The protection circuit 130 includes a comparator circuit 131 and a second transistor 132.

A control end of the control voltage circuit 111 is configured to receive a control signal. An input end of the control voltage circuit 111 is configured to input a power supply voltage. An output end of the control voltage circuit 111 is coupled to a gate of the first transistor 112, and outputs a coupling voltage or is configured to output a control voltage generated based on the control signal. The coupling voltage and the control voltage control a first electrode of the first transistor 112 to output a first voltage to the coupling point 140. The first voltage is used to control the programming circuit 120 to output the programming voltage to the memory cell 210. An input end of the comparator circuit 131 is configured to input a power supply voltage. An output end of the comparator circuit 131 is coupled to a gate of the second transistor 132, and is configured to output a fourth voltage when the power supply voltage is less than a preset value. The fourth voltage is used to control a first electrode of the second transistor 132 to output a second voltage.

The first electrode of the first transistor 112 in the drive circuit 110 and the first electrode of the second transistor 132 in the protection circuit 130 are jointly coupled to an electrode of the programming circuit 120. A drive capability of the second transistor 132 is greater than a drive capability of the first transistor 112. When the first electrode of the first transistor 112 outputs the first voltage to the coupling point 140, the programming circuit 120 outputs the programming voltage to the memory cell 210. When the first electrode of the first transistor 112 outputs the first voltage to the coupling point 140, and the first electrode of the second transistor 132 outputs the second voltage to the coupling point 140, because the drive capability of the second transistor 132 is greater than the drive capability of the first transistor 112, at the coupling point 140, the second voltage output by the first electrode of the second transistor 132 pulls up a voltage at the coupling point 140, and the programming circuit 120 outputs, to the memory cell 210, a low voltage that is insufficient to program the memory cell 210.

For example, as shown in FIG. 4, in a power-on phase, when programming power-on is performed before drive power-on, the power supply voltage is input to the control voltage circuit 111. The power supply voltage starts to gradually increase, and tends to be stable after reaching the preset value.

Before the power supply voltage increases to the preset value, as the power supply voltage increases, the control voltage circuit 111 generates a floating signal, and generates a coupling voltage under capacitive coupling effect caused by the programming voltage. The control voltage circuit 111 outputs the generated coupling voltage to the gate of the first transistor 112. The first transistor 112 is turned on because the gate receives the coupling voltage. The turned-on first transistor 112 outputs the first voltage to the coupling point 140 via the first electrode of the first transistor 112. The first electrode of the second transistor 132 outputs the second voltage to the coupling point 140. The first voltage and the second voltage work together to obtain a voltage at the coupling point 140, and the voltage at the coupling point 140 is used to control the programming circuit 120 to output a low voltage to the memory cell 210.

After the power supply voltage reaches the preset value, the power supply voltage tends to be stable. In this case, the floating signal inside the control voltage circuit 111 disappears, and the control voltage circuit 111 stops outputting the coupling voltage to the first transistor 112. The first transistor 112 is turned off, the first electrode of the first transistor 112 does not output the first voltage to the coupling point 140, and the programming circuit 120 outputs a low voltage to the memory cell 210.

In this embodiment of this application, in the electrically program fuse memory 1 shown in FIG. 4, preliminary interference filtering is performed on the coupling voltage via the first transistor 112 disposed in the drive circuit 110. A specific filtering principle is as follows: When the coupling voltage input to the gate of the first transistor 112 is higher than a specific value, the first transistor 112 is turned on, resulting in incorrect programming. Therefore, for a coupling voltage that does not reach a threshold voltage of the first transistor 112, interference filtering may be performed via the first transistor 112. However, the coupling voltage is an uncontrollable voltage, and it cannot be ensured that the coupling voltage can be completely isolated via the first transistor 112. In addition, the first transistor 112 cannot be a transistor that requires an excessively high voltage to be turned on, because to meet subsequent normal programming work, it also needs to be ensured that the first transistor 112 can be stably turned on via the control voltage. Based on this case, the protection circuit 130 is disposed. The comparator circuit 131 of the protection circuit 130 determines whether the power supply voltage reaches the preset value. When the power supply voltage does not reach the preset value, the first electrode of the second transistor 132 outputs the second voltage to the coupling point 140, and the programming circuit 120 is controlled to output a low voltage to the memory cell 210 via the voltage at the coupling point obtained by joint action of the second voltage and the first voltage.

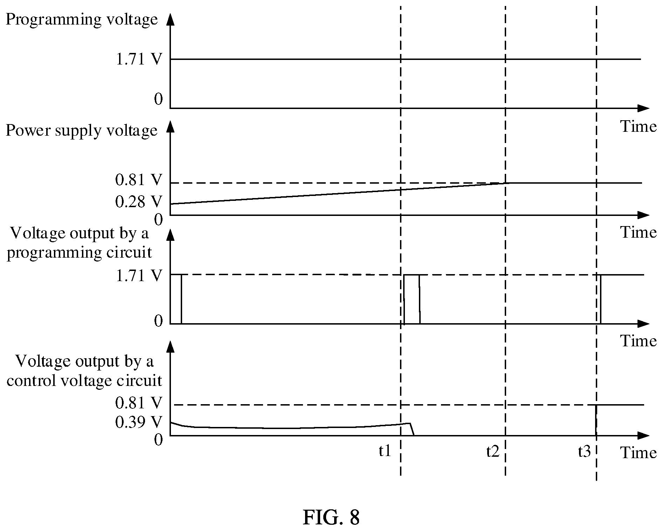

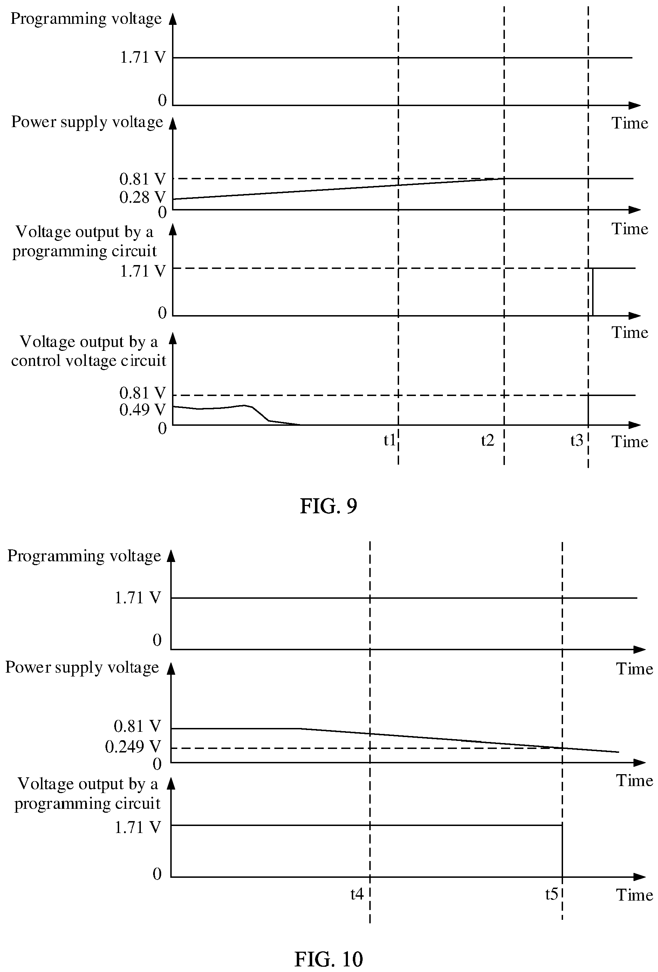

A design of the protection circuit 130 is based on a correlated relationship between the power supply voltage and the coupling voltage. FIG. 8 is a diagram of a power-on phase and a programming phase when the first transistor 112 is disposed in the drive circuit 110. FIG. 9 is a diagram of a power-on phase and a programming phase when the protection circuit 130 is further added based on the first transistor 112.

As shown in FIG. 8, when the power supply voltage is initially powered on, the control voltage circuit 111 generates the coupling voltage, and the coupling voltage is output to the gate of the first transistor 112. In an increase phase after the power supply voltage is powered on, the coupling voltage increases as the power supply voltage increases. At a moment t1, the coupling voltage reaches a degree to which the first transistor 112 can be turned on. In this case, the first transistor 112 is turned on, and the programming circuit 120 performs incorrect programming to output the programming voltage. As the power supply voltage continues to increase, the coupling voltage starts to decrease, the first transistor 112 is turned off, and the programming circuit 120 starts to output a low voltage. When the power supply voltage reaches the preset value at a moment t2 and tends to be stable, the coupling voltage disappears, the first transistor 112 remains off, and the programming circuit 120 continues to output a low voltage. Then, at a moment t3, the control signal is input to the control voltage circuit 111, the control voltage circuit 111 generates the control voltage and outputs the control voltage to the gate of the first transistor 112, and the programming circuit 120 starts to output the programming voltage.

However, after the protection circuit provided in this embodiment of this application is used, as shown in FIG. 9, in a power-on process, before a moment t1, the coupling circuit reaches a degree to which the first transistor 112 can be turned on. In this case, although the first transistor 112 is turned on, the second voltage output by the second transistor 132 in the protection circuit 130 is used to control the programming circuit 120 to output a low voltage. Before the moment t1, the coupling voltage disappears. Then, at a moment t2, the power supply voltage reaches a preset value that meets normal operation, and the second transistor 132 no longer outputs the second voltage to the programming circuit 120 from this moment. Then, at a moment t3, the control voltage circuit 111 generates the control voltage via the input control signal, and turns on the first transistor 112 via the control voltage, to control the programming circuit 120 to perform programming. In this embodiment of this application, the foregoing setting avoids incorrect programming of the programming circuit 120 due to the floating signal generated by the control voltage circuit 111 in combination with the capacitive coupling effect in a process in which the power supply voltage increases.

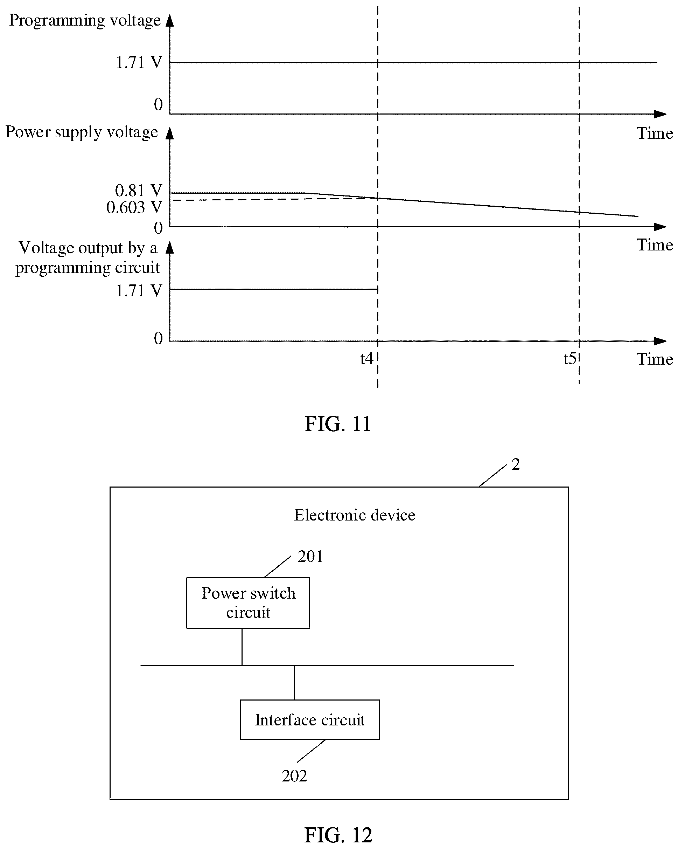

In addition, FIG. 10 is a diagram of a power-off phase when the first transistor 112 is disposed in the drive circuit 110. FIG. 11 is a diagram of a power-off phase when the protection circuit 130 is further added based on the first transistor 112. As shown in FIG. 10, the programming circuit 120 stops outputting the programming voltage only when the power supply voltage decreases to about 0.249 V. After the protection circuit 130 is disposed, as shown in FIG. 11, when the power supply voltage decreases to 0.603 V, the programming circuit 120 stops outputting the programming voltage. Therefore, in this embodiment of this application, in addition to avoiding incorrect programming of the programming circuit 120 in the power-on phase, the programming circuit 120 can respond to and stop programming more quickly in the power-off phase.

In some possible implementations, after the power supply voltage reaches the preset value and in the programming phase, as shown in FIG. 4, the comparator circuit 131 is configured to: when the received power supply voltage is greater than or equal to the preset value, output a third voltage to the gate of the second transistor 132. The third voltage is used to control the second transistor 132 to be turned off. That is, the second transistor 132 does not control the programming circuit 120 in the programming phase. The control voltage circuit 111 is configured to receive the control signal, and output the control voltage generated based on the control signal to the gate of the first transistor 112. The first transistor 112 is turned on because the gate receives the control voltage, so that the first voltage is output to the coupling point 140 via the first electrode of the first transistor 112, and the programming circuit 120 is controlled to output the programming voltage to the memory cell 210 via the first voltage.

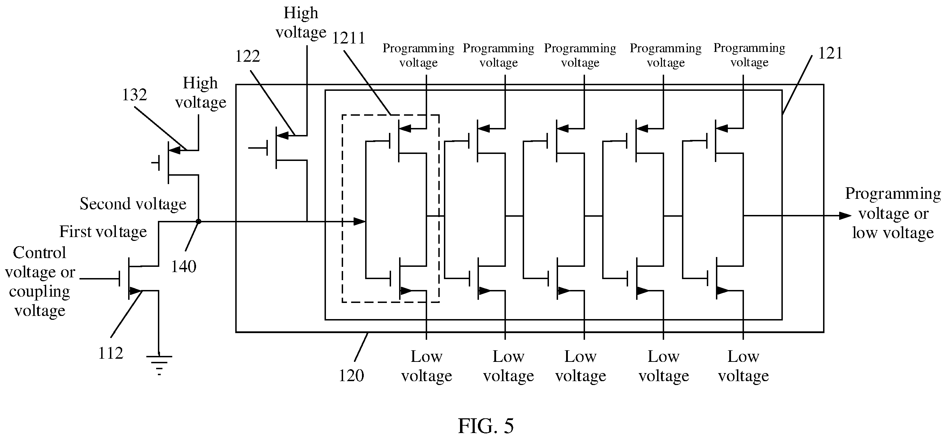

In some possible implementations, as shown in FIG. 5, the programming circuit 120 includes a programming power switch circuit 121 and a third transistor 122. A control end of the programming power switch circuit 121 is coupled to the first electrode of the first transistor 112, the first electrode of the second transistor 132, and a first electrode of the third transistor 122 together. A drive capability of the third transistor 122 is equal to or less than the drive capability of the first transistor. The first electrode of the third transistor 122 is configured to output a seventh voltage. The seventh voltage is used to control the programming power switch circuit 121 to output a low voltage to the memory cell 210. The programming power switch circuit 121 is configured to: input a programming voltage via an input end of the programming power switch circuit 121, and output the programming voltage to the memory cell 210 via an output end of the programming power switch circuit 121. If the first voltage is input to the control end of the programming power switch circuit 121, a low voltage that is insufficient to program the memory cell 210 is output to the memory cell 210. If the seventh voltage is input to the control end of the programming power switch circuit 121, a programming voltage is output to the memory cell 210.

For example, the first transistor 112 is an NMOS transistor, a drain of the first transistor 112 is used as a first electrode to output the first voltage, and a source is used as a second electrode. The second transistor 132 is a PMOS transistor, a drain of the second transistor 132 is used as the first electrode to output the second voltage, and a source is used as a second electrode to receive a high voltage. The third transistor 122 is a PMOS transistor, a drain of the third transistor 122 is used as the first electrode to output the seventh voltage, and a source is used as a second electrode to receive a high voltage. The programming power switch circuit 121 includes an odd quantity of inverter components 1211. For a single inverter component 1211, one NMOS transistor and one PMOS transistor are included. A gate of the PMOS transistor of the inverter component 1211 and a gate of the NMOS transistor of the inverter component 1211 are coupled and then used as a control end of the inverter component 1211. A drain of the PMOS transistor of the inverter component 1211 and a drain of the NMOS transistor of the inverter component 1211 are coupled and then used as an output end of the inverter component 1211. A source of the PMOS transistor of the inverter component 1211 is used as a first input end of the inverter component 1211 to input the programming voltage. A source of the NMOS transistor of the inverter component 1211 is used as a second input end of the inverter component 1211 to input a low voltage. When there are a plurality of inverter components 1211, the plurality of inverter components 1211 are cascaded by coupling an output end of a previous-stage inverter component 1211 to a control end of a next-stage inverter component 1211.

Before drive power-on, the power supply voltage is 0. A low voltage is continuously input to a gate of the third transistor 122 of the PMOS transistor, so that the third transistor 122 remains turned on, and a high voltage is input to the second electrode of the third transistor 122, so that the first electrode of the turned-on third transistor 122 outputs a high-voltage seventh voltage to the coupling point 140. For the single inverter component 1211, when a high voltage is input to the control end, the output end outputs a low voltage, and when a low voltage is input to the control end, the output end outputs the programming voltage. The programming power switch circuit 121 continuously outputs a low voltage to the memory cell 210 via the high-voltage seventh voltage and the odd quantity of inverter components 1211.

When drive power-on is performed after programming power-on, before the power supply voltage reaches the preset value, the control voltage circuit 111 generates the coupling voltage, and the coupling voltage is output to the gate of the first transistor 112. After receiving a high-voltage coupling voltage, the first transistor 112 used as the NMOS transistor is in a turned on state. Because the drive capability of the third transistor 122 is less than or equal to the drive capability of the first transistor 112, the first transistor 112 pulls, via the first electrode, a current output by the first electrode of the third transistor to the second electrode of the first transistor 112. In this case, the second electrode of the first transistor 112 is grounded, the first electrode of the third transistor 122 does not provide the seventh voltage to the programming power switch circuit 121, but the first electrode of the first transistor 112 provides the low-voltage first voltage to the programming power switch circuit 121. If the low-voltage first voltage is directly input to the programming power switch circuit 121, incorrect programming of the programming power switch circuit 121 is caused, and the programming voltage is output. However, in this case, because the power supply voltage is less than the preset value, after the power supply voltage that is less than the preset value is input to the comparator circuit of the protection circuit 130, the low-voltage fourth voltage is input to the gate of the second transistor 132 via the output end. The low-voltage fourth voltage enables the second transistor 132 used as the PMOS transistor to be turned on. A high voltage is input to the second electrode of the second transistor 132, so that the first electrode of the turned-on second transistor 132 outputs the high-voltage second voltage to the coupling point 140. In this case, because the drive capability of the second transistor 132 is greater than the drive capability of the first transistor 112, the high-voltage second voltage output by the first electrode of the second transistor 132 is dominant at the coupling point 140 compared with the low-voltage first voltage. Further, when both the first voltage and the second voltage are output to the coupling point 140, the second voltage pulls up the voltage at the coupling point 140. In this way, a high voltage is input to the control end of the programming power switch circuit 121 via the coupling point 140, and a low voltage instead of a high voltage is output to the memory cell 210 from the output end.

After drive power-on, the power supply voltage tends to be stable. In this case, a power supply voltage greater than or equal to the preset value is input to the comparator circuit 131, and the high-voltage third voltage is output to the gate of the second transistor 132. The second transistor 132 used as the PMOS transistor is turned off because the gate receives a high voltage, and no longer outputs the second voltage to the coupling point 140. Because the power supply voltage tends to be stable, impact of the capacitive coupling effect decreases or disappears, so that the coupling voltage in the control voltage circuit 111 decreases, a voltage of the gate of the first transistor 112 changes to a low voltage, and the first transistor 112 used as the NMOS transistor is turned off. The first electrode of the third transistor 122 directly outputs the seventh voltage to the programming power switch circuit 121, and the programming power switch circuit 121 is controlled to output a low voltage to the memory cell 210 via the seventh voltage.

After the programming phase starts, the control signal is input to the control voltage circuit 111. When programming needs to be performed, the control signal indicates the control voltage circuit 111 to generate the control voltage, and the first transistor 112 is turned on via the high-voltage control voltage. Therefore, the first electrode of the first transistor 112 pulls the current output by the first electrode of the third transistor 122, the first electrode of the first transistor 112 outputs the low-voltage first voltage, and the programming power switch circuit 121 is controlled to output the programming voltage to the memory cell 210 via the first voltage. When programming is not required, the control signal indicates the control voltage circuit 111 not to generate the control voltage, so that the first transistor 112 is not turned on because a low voltage is input to the gate. In this case, the first electrode of the third transistor 122 outputs the seventh voltage to the coupling point 140, and the programming power switch circuit 121 is controlled to output a low voltage to the memory cell 210 via the seventh voltage.

For example, the seventh voltage input to the second electrode of the third transistor 122 may be provided by the programming voltage. A continuous programming voltage is input to the second electrode of the third transistor 122 via the programming voltage, so that the first electrode of the third transistor 122 continuously outputs the seventh voltage to the coupling point 140.

The seventh voltage is generated via the programming voltage, and no additional power supply needs to be disposed. In addition, a function of the seventh voltage is to control, after the programming voltage is powered on, the programming circuit 120 to output a low voltage instead of the programming voltage to the memory cell 210. Therefore, the seventh voltage is generated via the programming voltage, so that the seventh voltage and the programming voltage can also be synchronized, thereby improving circuit stability.

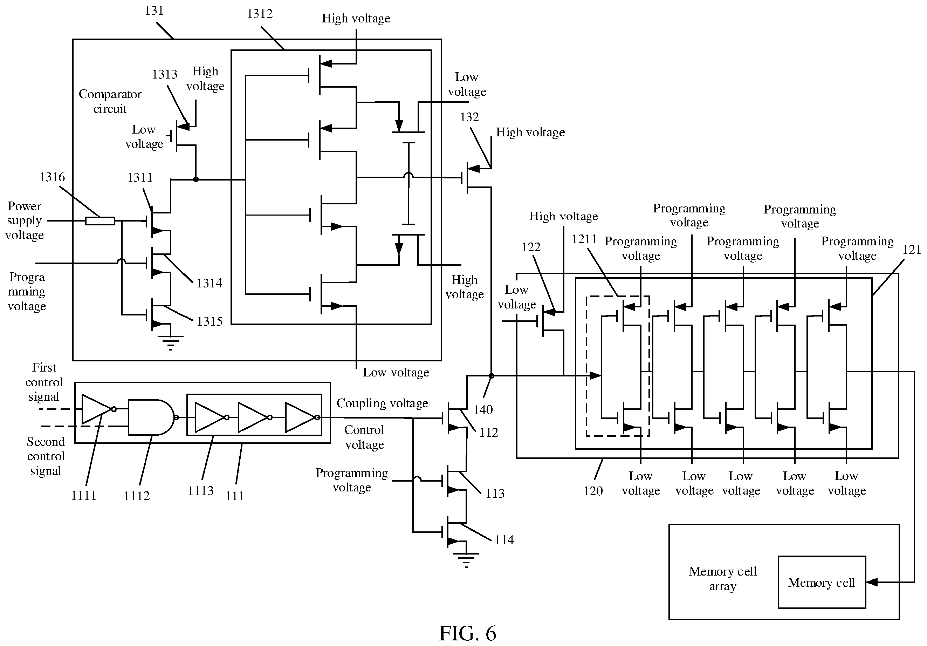

In the embodiment of the invention, as shown in FIG. 6, the drive circuit 110 further includes a fourth transistor 113. A first electrode of the fourth transistor 113 is coupled to the second electrode of the first transistor, a second electrode of the fourth transistor is grounded, and a gate of the fourth transistor is receives the programming voltage. The programming voltage is used to turn on the fourth transistor.

For example, the fourth transistor 113 is an NMOS transistor. When the programming voltage is input to the gate of the fourth transistor 113, the gate is a high voltage. In this case, the fourth transistor 113 is turned on.

In this embodiment of this application, the fourth transistor 113 is disposed, so that the fourth transistor 113 can be turned on and grounded only after programming power-on is completed, that is, when the programming voltage is input. In this case, the first transistor 112 is turned on and grounded, to pull down the voltage at the coupling point 140 and output the first voltage. However, when no programming voltage is input, the fourth transistor 113 is not turned on. In this case, regardless of whether the first transistor 112 is turned on, the voltage at the coupling point 140 is not pulled down, to ensure that the programming power switch circuit 121 always outputs a low voltage when there is no programming voltage.

In some possible implementations, as shown in FIG. 5, the drive circuit 110 further includes a fifth transistor 114. A gate of the fifth transistor 114 and the gate of the first transistor 112 are connected in parallel, and jointly receive the coupling voltage or the control voltage. A first electrode of the fifth transistor 114 is connected to the second electrode of the fourth transistor 113, and a second electrode of the fifth transistor 114 is grounded.

For example, the fifth transistor 114 is an NMOS transistor. The fourth transistor 113 is used to implement off or on between the first transistor 112 and the fifth transistor 114. Voltage division is implemented by disposing the fifth transistor 114. When the coupling voltage is generated, the first transistor 112 can be turned on only when the coupling voltage reaches a critical value. Therefore, the first transistor 112 may perform interference filtering on a coupling voltage less than the specific critical value. However, when the coupling voltage is higher than the specific critical value and the first transistor 112 is turned on, the second transistor 132 needs to output the second voltage to eliminate impact caused by the coupling voltage. The critical value may be increased by setting the fifth transistor 114 to divide a voltage.

In some possible implementations, as shown in FIG. 6, the comparator circuit 131 includes a sixth transistor 1311, a Schmitt trigger 1312, and a seventh transistor 1313. A first electrode of the sixth transistor 1311 and a first electrode of the seventh transistor 1313 are jointly coupled to an input end of the Schmitt trigger 1312. A second electrode of the sixth transistor 1311 is grounded. A gate of the sixth transistor 1311 is used as a control end of the comparator circuit 131 and is configured to input a power supply voltage. When the power supply voltage is less than the preset value, the first electrode of the seventh transistor 1313 is configured to output a fifth voltage to the input end of the Schmitt trigger 1312. The fifth voltage is used to control the Schmitt trigger 1312 to output a fourth voltage. When the power supply voltage is greater than or equal to the preset value, the sixth transistor 1311 is turned on because the gate receives the power supply voltage. The first electrode of the sixth transistor 1311 is configured to output a sixth voltage to the input end of the Schmitt trigger 1312. The sixth voltage is used to control the Schmitt trigger 1312 to output a third voltage.

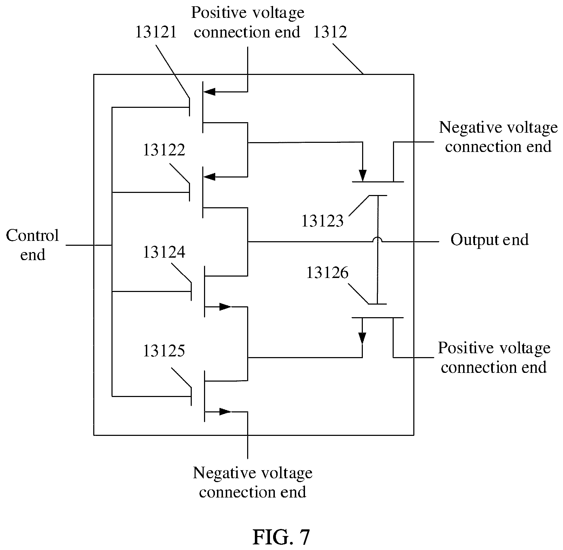

For example, FIG. 7 shows the Schmitt trigger 1312 including a MOS transistor. The Schmitt trigger 1312 includes a first PMOS transistor 13121, a second PMOS transistor 13122, a third PMOS transistor 13123, a first NMOS transistor 13124, a second NMOS transistor 13125, and a third NMOS transistor 13126. A gate of the first PMOS transistor 13121, a gate of the second PMOS transistor 13122, a gate of the first NMOS transistor 13124, and a gate of the second NMOS transistor 13125 are connected in parallel and then used as a control end of the Schmitt trigger 1312. A drain of the second PMOS transistor 13122 and a drain of the first NMOS transistor 13124 are connected in parallel and then used as an output end of the Schmitt trigger 1312. A drain of the first PMOS transistor 13121 and a source of the second PMOS transistor 13122 are connected in parallel, and then are connected to a source of the third PMOS transistor 13123. A source of the first NMOS transistor 13124 and a drain of the second NMOS transistor 13125 are connected in parallel, and then are connected to a source of the third NMOS transistor 13126. A gate of the third PMOS transistor 13123 is connected to a gate of the third NMOS transistor 13126. A source of the first PMOS transistor 13121 and a drain of the third NMOS transistor 13126 are separately used as positive voltage connection ends of the Schmitt trigger 1312, and are configured to receive a high voltage signal. A source of the second NMOS transistor 13125 and a drain of the third PMOS transistor 13123 are separately used as negative voltage connection ends of the Schmitt trigger 1312, and are configured to receive a low voltage signal. Compared with a general trigger, the Schmitt trigger 1312 has two stable states, and the Schmitt trigger 1312 uses a potential triggering manner, and a state of the Schmitt trigger 1312 is maintained by an input signal potential. For input signals in two different change directions: negative decrease and positive increase, the Schmitt trigger 1312 has different threshold voltages, which are respectively referred to as a positive threshold voltage and a negative threshold voltage. The positive threshold voltage and the negative threshold voltage are determined by adjusting voltages corresponding to voltages input to the positive voltage connection end and the negative voltage connection end of the Schmitt trigger 1312. In a process in which the voltage input to the control end increases from a low voltage to a high voltage, when the input voltage reaches a voltage value of the positive threshold voltage, a circuit status of the Schmitt trigger 1312 changes, to output a low voltage. In a process in which the voltage input to the control end decreases from a high voltage to a low voltage, when the input voltage reaches a voltage value of the negative threshold voltage, a circuit status of the Schmitt trigger 1312 changes, to output a high voltage.

For example, as shown in FIG. 6, the sixth transistor 1311 is an NMOS transistor, and the seventh transistor 1313 is a PMOS transistor. A low voltage is continuously input to a gate of the seventh transistor 1313, so that the seventh transistor serving as the PMOS transistor is always turned on. A high voltage is input to a source that is of the turned-on seventh transistor 1313 and that is used as a second electrode, so that the seventh transistor 1313 outputs the high-voltage fifth voltage to the input end of the Schmitt trigger 1312. When the power supply voltage does not reach the preset value, the sixth transistor 1311 used as the NMOS transistor is not turned on because the gate is at a low voltage. In this case, after the input end of the Schmitt trigger 1312 receives the high-voltage fifth voltage, the low-voltage fourth voltage is output to the gate of the second transistor 132 via the output end. The second transistor 132 is the PMOS transistor, and is turned on because the gate receives the low-voltage fourth voltage, so that the second voltage is output via the first electrode of the second transistor 132. When the power supply voltage reaches the preset value, a high voltage is provided for the gate of the sixth transistor 1311, so that the sixth transistor 1311 is turned on. The turned-on sixth transistor 1311 pulls a current output by the first electrode of the seventh transistor 1313 from the input end of the Schmitt trigger 1312 to the second electrode that is of the sixth transistor 1311 and that is grounded. In this case, the first electrode of the sixth transistor 1311 outputs the low-voltage sixth voltage to the input end of the Schmitt trigger 1312. After receiving the low-voltage sixth voltage, the input end of the Schmitt trigger 1312 outputs the high-voltage third voltage to the gate of the second transistor 132, so that the second transistor 132 that is the PMOS transistor is turned off because the high-voltage third voltage is input to the gate.

For example, the fifth voltage input to the source that is of the seventh transistor 1313 and that is used as the second electrode may be provided by the programming voltage. The fifth voltage input to the second electrode of the seventh transistor 1313 is provided by the programming voltage. This reduces setting of additional power supply. In addition, synchronization between the fifth voltage output by the first electrode of the seventh transistor 1313 and the programming voltage can be ensured, thereby improving system stability.

In some possible implementations, as shown in FIG. 6, the comparator circuit 131 further includes an eighth transistor 1314. A first electrode of the eighth transistor 1314 is coupled to the second electrode of the sixth transistor 1311, and a second electrode of the eighth transistor 1314 is grounded. The eighth transistor 1314 is turned on because a programming voltage is input to a gate.

For example, the eighth transistor 1314 is an NMOS transistor. After the programming voltage is powered on, a high voltage is input to the gate of the eighth transistor 1314, so that the eighth transistor 1314 is turned on, and the second electrode of the sixth transistor 1311 is grounded via the eighth transistor 1314. After the programming voltage is powered off, the eighth transistor 1314 is turned off. Via the eighth transistor 1314, it can be ensured that the second electrode of the sixth transistor 1311 can be grounded only after the programming power-on, so that the low-voltage first voltage is output via the first electrode.

In some possible implementations, as shown in FIG. 6, the comparator circuit 131 further includes a ninth transistor 1315. A first electrode of the ninth transistor 1315 is coupled to the second electrode of the eighth transistor 1314, and a second electrode of the ninth transistor 1315 is grounded. A gate of the ninth transistor 1315 is connected in parallel to the gate of the sixth transistor 1311.

For example, the ninth transistor 1315 is an NMOS transistor, and is configured to divide a voltage and increase a critical value of a power supply voltage for turning on the sixth transistor 1311.

In some possible implementations, as shown in FIG. 6, the comparator circuit 131 further includes a first resistor 1316. An input end of the first resistor 1316 is configured to input a power supply voltage, and an output end is configured to output the power supply voltage to the gate of the sixth transistor 1311.

A current for supplying the power supply voltage is generally large, and the current may be limited via the first resistor 1316, to protect the sixth transistor 1311 and the ninth transistor 1315 from being damaged due to an excessively large current.

It should be noted that, in the foregoing embodiments, the description that different voltage signals are high-voltage signals or low-voltage signals is merely an actual example. However, in actual application, only a quantity of second inverters in an inverter group 1113 in the control voltage circuit 111 and a quantity of inverter components 1211 in the programming circuit 120 need to be changed, and whether the first transistor 112, the second transistor 132, the third transistor 122, and the like are specifically PMOS transistors or NMOS transistors is adaptively adjusted, so that different implementations such as low-voltage control or high-voltage control can be implemented.

As shown in FIG. 12, an embodiment of this application further provides an electronic device 2. The electronic device 2 includes a power switch circuit 201 described in the foregoing embodiments and an interface circuit 202. The power switch circuit 201 is configured to: input a power supply voltage, a control signal, and a programming voltage; and output, based on the control signal, the programming voltage to the memory cell in the coupled memory cell array via the interface circuit 202. The programming voltage is used to program the memory cell.

For example, the electronic device 2 may be a handheld terminal, a computer, a dedicated programming device, or the like.

A person of ordinary skill in the art may be aware that, in combination with examples described in embodiments disclosed in this specification, modules and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and module, refer to a corresponding process in the foregoing method embodiments, and details are not described herein again.

In several embodiments provided in this application, it should be understood that division into the modules is merely logical function division and may be other division in actual implementation. For example, a plurality of modules or components may be combined or integrated into another device, or some features may be ignored or not performed. In addition, the displayed or discussed mutual couplings or direct couplings or communication connections may be implemented through some interfaces. The indirect couplings or communication connections between the devices or modules may be implemented in electronic, mechanical, or other forms.

The modules described as separate components may or may not be physically separate, and components displayed as modules may be located in one device, or may be distributed on a plurality of devices. Some or all the modules may be selected based on actual needs to achieve objectives of the solutions of embodiments.

In addition, functional modules in embodiments of this application may be integrated into one device, or each of the modules may exist alone physically, or two or more modules are integrated into one device.

The foregoing descriptions are merely specific implementations of this application, but are not intended to limit the protection scope of this application. The protection scope of this application shall be subject to the protection scope of the claims.

## Claims

1. A power switch circuit (10, 201), wherein the power switch circuit (10, 201) is configured to be coupled to a memory cell (210) in a memory cell array (20), to output a programming voltage to the memory cell (210), the programming voltage is used to program the memory cell (210), the power switch circuit (10, 201) comprises a drive circuit (110), a programming circuit (120), and a protection circuit (130), the drive circuit (110) is powered by a power supply voltage, the programming circuit (120) is powered by the programming voltage, the drive circuit (110) comprises a control voltage circuit (111) and a first transistor (112), and the protection circuit (130) comprises a comparator circuit (131) and a second transistor (132), wherein a control end of the comparator circuit receives the power supply voltage and the comparator circuit (131) is configured to compare the power supply voltage with a preset value;
an output end of the control voltage circuit (111) is coupled to a gate of the first transistor (112), a first electrode of the first transistor (112) is used as an output end of the drive circuit (110) and is coupled to a control end of the programming circuit (120) at a coupling point (140), a first electrode of the second transistor (132) is coupled at the coupling point (140), and an output end of the comparator circuit (131) is coupled to a gate of the second transistor (132); an output end of the programming circuit (120) is configured to be coupled to the memory cell (210), and is configured to output the programming voltage;
wherein the protection circuit, the drive circuit and the programming circuit are such that when the power supply voltage is less that the preset-value, a low voltage insufficient to program the memory cell is output by the programming circuit; **characterized in that**
a drive capability of the second transistor (132) is greater than a drive capability of the first transistor (112); and
the drive circuit (110) further comprises a third transistor (113), a first electrode of the third transistor (113) is coupled to a second electrode of the first transistor (112), a second electrode of the third transistor (113) is grounded, a gate of the third transistor (113) receives the programming voltage, and the programming voltage is used to turn on the third transistor (113), wherein the third transistor (113) is configured to ensure that the programming circuit (120) always outputs a low voltage when there is no programming voltage.

2. The circuit according to claim 1, wherein the comparator circuit (131) comprises a sixth transistor (1311), a seventh transistor (1313), and a Schmitt trigger (1312);
a gate of the sixth transistor (1311) is used as an input end of the comparator circuit (131) and is connected to the power supply voltage, a first electrode of the sixth transistor (1311) and a first electrode of the seventh transistor (1313) are jointly coupled to an input end of the Schmitt trigger (1312), and a second electrode of the sixth transistor (1311) is grounded; and
an output end of the Schmitt trigger (1312) is used as the output end of the comparator circuit (131) and is coupled to the gate of the second transistor (132).

3. The circuit according to claim 2, wherein the comparator circuit (131) further comprises an eighth transistor (1314); and
a gate of the eighth transistor (1314) is connected to the programming voltage, the programming voltage is used to control the eighth transistor (1314) to be turned on, a first electrode of the eighth transistor (1314) is coupled to the second electrode of the sixth transistor (1311), and a second electrode of the eighth transistor (1314) is grounded.

4. The circuit according to claim 3, wherein the comparator circuit (131) further comprises a ninth transistor (1315); and
a first electrode of the ninth transistor (1315) is coupled to the second electrode of the eighth transistor (1314), a second electrode of the ninth transistor (1315) is grounded, and a gate of the ninth transistor (1315) and the gate of the sixth transistor (1311) are connected in parallel, and are used as the input end of the comparator circuit (131) to input the power supply voltage.

5. The circuit according to any one of claims 2 to 4, wherein the comparator circuit (131) further comprises a first resistor (1316); and
an input end of the first resistor (1316) is connected to the power supply voltage, and an output end of the first resistor (1316) is coupled to the gate of the sixth transistor (1311), and is configured to output the power supply voltage.

6. The circuit according to claim 1, wherein the programming circuit (120) comprises a fourth transistor (122) and a programming power switch circuit (121);
a control end of the programming power switch circuit (121) is used as the control end of the programming circuit (120), and is coupled to the coupling point (140) together with the first electrode of the first transistor (112), the first electrode of the second transistor (132), and a first electrode of the fourth transistor (122), and an output end of the programming power switch circuit (121) is used as the output end of the programming circuit (120), and is configured to be coupled to the memory cell (210), to output the programming voltage to the memory cell (210); and
a drive capability of the fourth transistor (122) is equal to or less than the drive capability of the first transistor (112).

7. The circuit according to claim 6, wherein the programming power switch circuit (121) comprises an odd quantity of inverter components (1211);
a single inverter component comprises an NMOS transistor and a PMOS transistor, a gate of the PMOS transistor of the inverter component (1211) and a gate of the NMOS transistor of the inverter component (1211) are coupled and then used as a control end of the inverter component (1211), a drain of the PMOS transistor of the inverter component (1211) and a drain of the NMOS transistor of the inverter component (1211) are coupled and then used as an output end of the inverter component (1211), and a source of the PMOS transistor of the inverter component (1211) is connected to the programming voltage; and
when the programming power switch circuit (121) comprises a single inverter component, a control end of the single inverter component is used as the control end of the programming power switch circuit (121), and is coupled to the coupling point (140) together with the first electrode of the first transistor (112), the first electrode of the second transistor (132), and the first electrode of the fourth transistor (122), and an output end of the single inverter component is used as the output end of the programming power switch circuit (121), and is configured to be coupled to the memory cell (210), to output the programming voltage to the memory cell (210); or
when the programming power switch circuit (121) comprises a plurality of inverter components (1211), an output end of a previous-stage inverter component is coupled to a control end of a next-stage inverter component, a control end of a first-stage inverter component is used as the control end of the programming power switch circuit (121), and is coupled to the coupling point (140) together with the first electrode of the first transistor (112), the first electrode of the second transistor (132), and the first electrode of the fourth transistor (122), and an output end of a last-stage inverter component is used as the output end of the programming power switch circuit (121), and is configured to be coupled to the memory cell (210), to output the programming voltage to the memory cell (210).

8. The circuit according to claim 6 or 7, wherein a second electrode of the fourth transistor (122) is connected to the programming voltage.

9. The circuit according to claim 1, wherein the control voltage circuit (111) comprises a first inverter (1111), a NAND gate (1112), and an inverter group (1113), and the inverter group (1113) comprises an odd quantity of second inverters; and an input end of the first inverter (1111) is configured to receive a first control signal, an output end of the first inverter (1111) is coupled to a first input end of the NAND gate (1112), a second input end of the NAND gate (1112) is configured to be connected to a second control signal, an output end of the NAND gate (1112) is connected to an input end of the inverter group (1113), and an output end of the inverter group (1113) is used as the output end of the control voltage circuit (111) and is coupled to the gate of the first transistor (112), and is configured to output a control voltage.

10. The circuit according to any one of claims 1 to 9, wherein the drive circuit (110) further comprises a fifth transistor (114), a gate of the fifth transistor (114) is connected in parallel to the gate of the first transistor (112), and is configured to be coupled to the output end of the control voltage circuit (111), a first electrode of the fifth transistor (114) is coupled to the second electrode of the third transistor (113), and a second electrode of the fifth transistor (114) is grounded.

11. The circuit according to any one of claims 1 to 10, wherein a second electrode of the second transistor (132) is connected to the programming voltage.

12. An electrically program fuse memory, wherein the electrically program fuse memory comprises the power switch circuit (10, 201) according to any one of claims 1 to 11 and a memory cell array (20); the power switch circuit (10, 201) is configured to: receive a control signal, and output, based on the control signal, the programming voltage to a memory cell (210) in the coupled memory cell array.

13. An electronic device (2), wherein the electronic device (2) comprises the power switch circuit (10, 201) according to any one of claims 1 to 11; the power switch circuit (10, 201) is configured to receive a control signal, and output, based on the control signal, the programming voltage to a memory cell (210) in a coupled memory cell array.

## Patentansprüche

1. Leistungsschaltkreis (10, 201), wobei der Leistungsschaltkreis (10, 201) dazu konfiguriert ist, mit einer Speicherzelle (210) in einem Speicherzellenarray (20) gekoppelt zu sein, um eine Programmierspannung an die Speicherzelle (210) auszugeben, wobei die Programmierspannung verwendet wird, um die Speicherzelle (210) zu programmieren, wobei der Leistungsschaltkreis (10, 201) einen Ansteuerkreis (110), einen Programmierkreis (120) und einen Schutzkreis (130) umfasst, wobei der Ansteuerkreis (110) durch eine Leistungsversorgungsspannung mit Leistung versorgt wird, der Programmierkreis (120) durch die Programmierspannung mit Leistung versorgt wird, der Ansteuerkreis (110) einen Steuerspannungskreis (111) und einen ersten Transistor (112) umfasst und der Schutzkreis (130) einen Komparatorkreis (131) und einen zweiten Transistor (132) umfasst, wobei ein Steuerende des Komparatorkreises die Leistungsversorgungsspannung aufnimmt und der Komparatorkreis (131) dazu konfiguriert ist, die Leistungsversorgungsspannung mit einem voreingestellten Wert zu vergleichen;
ein Ausgangsende des Steuerspannungskreises (111) mit einem Gate des ersten Transistors (112) gekoppelt ist, eine erste Elektrode des ersten Transistors (112) als ein Ausgangsende des Ansteuerkreises (110) verwendet wird und mit einem Steuerende des Programmierkreises (120) an einem Kopplungspunkt (140) gekoppelt ist, eine erste Elektrode des zweiten Transistors (132) an dem Kopplungspunkt (140) gekoppelt ist und ein Ausgangsende des Komparatorkreises (131) mit einem Gate des zweiten Transistors (132) gekoppelt ist;
ein Ausgangsende des Programmierkreises (120) dazu konfiguriert ist, mit der Speicherzelle (210) gekoppelt zu sein, und dazu konfiguriert ist, die Programmierspannung auszugeben;
wobei der Schutzkreis, der Ansteuerkreis und der Programmierkreis derart sind, dass, wenn die Leistungsversorgungsspannung geringer als der voreingestellte Wert ist, eine niedrige Spannung durch den Programmierkreis ausgegeben wird, die nicht ausreicht, um die Speicherzelle zu programmieren;
**dadurch gekennzeichnet, dass**
ein Ansteuervermögen des zweiten Transistors (132) größer als ein Ansteuervermögen des ersten Transistors (112) ist; und
der Ansteuerkreis (110) ferner einen dritten Transistor (113) umfasst, eine erste Elektrode des dritten Transistors (113) mit einer zweiten Elektrode des ersten Transistors (112) gekoppelt ist, eine zweite Elektrode des dritten Transistors (113) geerdet ist, ein Gate des dritten Transistors (113) die Programmierspannung aufnimmt und die Programmierspannung verwendet wird, um den dritten Transistor (113) einzuschalten, wobei der dritte Transistor (113) dazu konfiguriert ist, sicherzustellen, dass der Programmierkreis (120) immer eine niedrige Spannung ausgibt, wenn keine Programmierspannung vorhanden ist.

2. Kreis nach Anspruch 1, wobei der Komparatorkreis (131) einen sechsten Transistor (1311), einen siebten Transistor (1313) und einen Schmitt-Trigger (1312) umfasst;
ein Gate des sechsten Transistors (1311) als ein Eingangsende des Komparatorkreises (131) verwendet wird und mit der Leistungsversorgungsspannung verbunden ist, eine erste Elektrode des sechsten Transistors (1311) und eine erste Elektrode des siebten Transistors (1313) gemeinsam mit einem Eingangsende des Schmitt-Triggers (1312) gekoppelt sind und eine zweite Elektrode des sechsten Transistors (1311) geerdet ist; und
ein Ausgangsende des Schmitt-Triggers (1312) als das Ausgangsende des Komparatorkreises (131) verwendet wird und mit dem Gate des zweiten Transistors (132) gekoppelt ist.

3. Kreis nach Anspruch 2, wobei der Komparatorkreis (131) ferner einen achten Transistor (1314) umfasst; und
ein Gate des achten Transistors (1314) mit der Programmierspannung verbunden ist, die Programmierspannung verwendet wird, um den achten Transistor (1314) so zu steuern, dass er eingeschaltet wird, eine erste Elektrode des achten Transistors (1314) mit der zweiten Elektrode des sechsten Transistors (1311) gekoppelt ist und eine zweite Elektrode des achten Transistors (1314) geerdet ist.

4. Kreis nach Anspruch 3, wobei der Komparatorkreis (131) ferner einen neunten Transistor (1315) umfasst; und
eine erste Elektrode des neunten Transistors (1315) mit der zweiten Elektrode des achten Transistors (1314) gekoppelt ist, eine zweite Elektrode des neunten Transistors (1315) geerdet ist und ein Gate des neunten Transistors (1315) und das Gate des sechsten Transistors (1311) parallel verbunden sind und als das Eingangsende des Komparatorkreises (131) zum Eingeben der Leistungsversorgungsspannung verwendet werden.

5. Kreis nach einem der Ansprüche 2 bis 4, wobei der Komparatorkreis (131) ferner einen ersten Widerstand (1316) umfasst; und
ein Eingangsende des ersten Widerstands (1316) mit der Leistungsversorgungsspannung verbunden ist und ein Ausgangsende des ersten Widerstands (1316) mit dem Gate des sechsten Transistors (1311) gekoppelt ist und dazu konfiguriert ist, die Leistungsversorgungsspannung auszugeben.

6. Kreis nach Anspruch 1, wobei der Programmierkreis (120) einen vierten Transistor (122) und einen Programmierleistungsschaltkreis (121) umfasst;
ein Steuerende des Programmierleistungsschaltkreises (121) als das Steuerende des Programmierkreises (120) verwendet wird und mit dem Kopplungspunkt (140) zusammen mit der ersten Elektrode des ersten Transistors (112), der ersten Elektrode des zweiten Transistors (132) und einer ersten Elektrode des vierten Transistors (122) gekoppelt ist und ein Ausgangsende des Programmierleistungsschaltkreises (121) als das Ausgangsende des Programmierkreises (120) verwendet wird und dazu konfiguriert ist, mit der Speicherzelle (210) gekoppelt zu sein, um die Programmierspannung an die Speicherzelle (210) auszugeben; und
ein Ansteuervermögen des vierten Transistors (122) gleich oder geringer als das Ansteuervermögen des ersten Transistors (112) ist.

7. Kreis nach Anspruch 6, wobei der Programmierleistungsschaltkreis (121) eine ungerade Anzahl von Inverterkomponenten (1211) umfasst;
eine einzelne Inverterkomponente einen NMOS-Transistor und einen PMOS-Transistor umfasst, ein Gate des PMOS-Transistors der Inverterkomponente (1211) und ein Gate des NMOS-Transistors der Inverterkomponente (1211) gekoppelt werden und dann als ein Steuerende der Inverterkomponente (1211) verwendet werden, ein Drain des PMOS-Transistors der Inverterkomponente (1211) und ein Drain des NMOS-Transistors der Inverterkomponente (1211) gekoppelt werden und dann als ein Ausgangsende der Inverterkomponente (1211) verwendet werden und eine Source des PMOS-Transistors des Inverterkomponente (1211) mit der Programmierspannung verbunden ist; und
wenn der Programmierleistungsschaltkreis (121) eine einzelne Inverterkomponente umfasst, ein Steuerende der einzelnen Inverterkomponente als das Steuerende des Programmierleistungsschaltkreises (121) verwendet wird und mit dem Kopplungspunkt (140) zusammen mit der ersten Elektrode des ersten Transistors (112), der ersten Elektrode des zweiten Transistors (132) und der ersten Elektrode des vierten Transistors (122) gekoppelt ist und ein Ausgangsende der einzelnen Inverterkomponente als das Ausgangsende des Programmierleistungsschaltkreises (121) verwendet wird und dazu konfiguriert ist, mit der Speicherzelle (210) gekoppelt zu sein, um die Programmierspannung an die Speicherzelle (210) auszugeben; oder
wenn der Programmierleistungsschaltkreis (121) eine Vielzahl von Inverterkomponenten (1211) umfasst, ein Ausgangsende einer Inverterkomponente der vorherigen Stufe mit einem Steuerende einer Inverterkomponente der nächsten Stufe gekoppelt wird, ein Steuerende der Inverterkomponente der ersten Stufe als das Steuerende des Programmierleistungsschaltkreises (121) verwendet wird und mit dem Kopplungspunkt (140) zusammen mit der ersten Elektrode des ersten Transistors (112), der ersten Elektrode des zweiten Transistors (132) und der ersten Elektrode des vierten Transistors (122) gekoppelt ist und ein Ausgangsende einer Inverterkomponente der letzten Stufe als das Ausgangsende des Programmierleistungsschaltkreises (121) verwendet wird und dazu konfiguriert ist, mit der Speicherzelle (210) gekoppelt zu sein, um die Programmierspannung an die Speicherzelle (210) auszugeben.

8. Kreis nach Anspruch 6 oder 7, wobei eine zweite Elektrode des vierten Transistors (122) mit der Programmierspannung verbunden ist.

9. Kreis nach Anspruch 1, wobei der Steuerspannungskreis (111) einen ersten Inverter (1111), ein NAND-Gate (1112) und eine Invertergruppe (1113) umfasst und die Invertergruppe (1113) eine ungerade Anzahl von zweiten Invertern umfasst; und
ein Eingangsende des ersten Inverters (1111) dazu konfiguriert ist, ein erstes Steuersignal zu empfangen, ein Ausgangsende des ersten Inverters (1111) mit einem ersten Eingangsende des NAND-Gate (1112) gekoppelt ist, ein zweites Eingangsende des NAND-Gate (1112) dazu konfiguriert ist, mit einem zweiten Steuersignal verbunden zu sein, ein Ausgangsende des NAND-Gate (1112) mit einem Eingangsende der Invertergruppe (1113) verbunden ist und ein Ausgangsende der Invertergruppe (1113) als das Ausgangsende des Steuerspannungskreises (111) verwendet wird und mit dem Gate des ersten Transistors (112) gekoppelt ist und dazu konfiguriert ist, eine Steuerspannung auszugeben.

10. Kreis nach einem der Ansprüche 1 bis 9, wobei der Ansteuerkreis (110) ferner einen fünften Transistor (114) umfasst, ein Gate des fünften Transistors (114) parallel mit dem Gate des ersten Transistors (112) verbunden ist und dazu konfiguriert ist, mit dem Ausgangsende des Steuerspannungskreises (111) gekoppelt zu sein, eine erste Elektrode des fünften Transistors (114) mit der zweiten Elektrode des dritten Transistors (113) gekoppelt ist und eine zweite Elektrode des fünften Transistors (114) geerdet ist.

11. Kreis nach einem der Ansprüche 1 bis 10, wobei eine zweite Elektrode des zweiten Transistors (132) mit der Programmierspannung verbunden ist.

12. Elektrischer Programmier-Sicherungsspeicher, wobei der elektrische Programmier-Sicherungsspeicher den Leistungsschaltkreis (10, 201) nach einem der Ansprüche 1 bis 11 und ein Speicherzellenarray (20) umfasst; wobei der Leistungsschaltkreis (10, 201) zu Folgendem konfiguriert ist: Empfangen eines Steuersignals und basierend auf dem Steuersignal Ausgeben der Programmierspannung an eine Speicherzelle (210) in dem gekoppelten Speicherzellenarray.

13. Elektronische Vorrichtung (2), wobei die elektronische Vorrichtung (2) den Leistungsschaltkreis (10, 201) nach einem der Ansprüche 1 bis 11 umfasst; der Leistungsschaltkreis (10, 201) dazu konfiguriert ist, ein Steuersignal zu empfangen und basierend auf dem Steuersignal die Programmierspannung an eine Speicherzelle (210) in einem gekoppelten Speicherzellenarray auszugeben.

## Revendications

1. Circuit de commutation de puissance (10, 201), dans lequel le circuit de commutation de puissance (10, 201) est configuré pour être couplé à une cellule de mémoire (210) dans un réseau de cellules de mémoire (20), afin de fournir une tension de programmation à la cellule de mémoire (210), la tension de programmation est utilisée pour programmer la cellule de mémoire (210), le circuit de commutation de puissance (10, 201) comprend un circuit de commande (110), un circuit de programmation (120) et un circuit de protection (130), le circuit de commande (110) est alimenté par une tension d'alimentation, le circuit de programmation (120) est alimenté par la tension de programmation, le circuit de commande (110) comprend un circuit de tension de commande (111) et un premier transistor (112) et le circuit de protection (130) comprend un circuit comparateur (131) et un deuxième transistor (132), dans lequel une extrémité de commande du circuit comparateur reçoit la tension d'alimentation et le circuit comparateur (131) est configuré pour comparer la tension d'alimentation à une valeur prédéfinie ;
une extrémité de sortie du circuit de tension de commande (111) est couplée à une grille du premier transistor (112), une première électrode du premier transistor (112) est utilisée comme extrémité de sortie du circuit de commande (110) et est couplée à une extrémité de commande du circuit de programmation (120) à un point de couplage (140), une première électrode du deuxième transistor (132) est couplée au point de couplage (140), et une extrémité de sortie du circuit comparateur (131) est couplée à une grille du deuxième transistor (132) ;
une extrémité de sortie du circuit de programmation (120) est configurée pour être couplée à la cellule de mémoire (210) et est configurée pour fournir la tension de programmation ;
dans lequel le circuit de protection, le circuit de commande et le circuit de programmation sont tels que, lorsque la tension d'alimentation est inférieure à la valeur prédéfinie, une tension basse insuffisante pour programmer la cellule de mémoire est fournie par le circuit de programmation ; **caractérisé en ce que**
la capacité de commande du deuxième transistor (132) est supérieure à la capacité de commande du premier transistor (112) ; et
le circuit de commande (110) comprend en outre un troisième transistor (113), une première électrode du troisième transistor (113) est couplée à une seconde électrode du premier transistor (112), une seconde électrode du troisième transistor (113) est mise à la terre, une grille du troisième transistor (113) reçoit la tension de programmation, et la tension de programmation est utilisée pour activer le troisième transistor (113), dans lequel le troisième transistor (113) est configuré pour garantir que le circuit de programmation (120) fournit toujours une tension basse lorsqu'il n'y a pas de tension de programmation.

2. Circuit selon la revendication 1, dans lequel le circuit comparateur (131) comprend un sixième transistor (1311), un septième transistor (1313) et un déclencheur de Schmitt (1312) ; une grille du sixième transistor (1311) est utilisée comme extrémité d'entrée du circuit comparateur (131) et est connectée à la tension d'alimentation, une première électrode du sixième transistor (1311) et une première électrode du septième transistor (1313) sont couplées conjointement à une entrée du déclencheur de Schmitt (1312), et une seconde électrode du sixième transistor (1311) est mise à la terre ; et
une extrémité de sortie du déclencheur de Schmitt (1312) est utilisée comme extrémité de sortie du circuit comparateur (131) et est couplée à la grille du deuxième transistor (132).

3. Circuit selon la revendication 2, dans lequel le circuit comparateur (131) comprend en outre un huitième transistor (1314) ; et
une grille du huitième transistor (1314) est connectée à la tension de programmation, la tension de programmation est utilisée pour commander l'activation du huitième transistor (1314), une première électrode du huitième transistor (1314) est couplée à la seconde électrode du sixième transistor (1311), et une seconde électrode du huitième transistor (1314) est mise à la terre.

4. Circuit selon la revendication 3, dans lequel le circuit comparateur (131) comprend en outre un neuvième transistor (1315) ; et
une première électrode du neuvième transistor (1315) est couplée à la seconde électrode du huitième transistor (1314), une seconde électrode du neuvième transistor (1315) est mise à la terre, et une grille du neuvième transistor (1315) et la grille du sixième transistor (1311) sont connectées en parallèle et sont utilisées comme extrémité d'entrée du circuit comparateur (131) pour entrer la tension d'alimentation.

5. Circuit selon l'une quelconque des revendications 2 à 4, dans lequel le circuit comparateur (131) comprend en outre une première résistance (1316) ; et
une extrémité d'entrée de la première résistance (1316) est connectée à la tension d'alimentation, et une extrémité de sortie de la première résistance (1316) est couplée à la grille du sixième transistor (1311) et est configurée pour fournir la tension d'alimentation.

6. Circuit selon la revendication 1, dans lequel le circuit de programmation (120) comprend un quatrième transistor (122) et un circuit de commutation d'alimentation de programmation (121) ;
une extrémité de commande du circuit de commutation d'alimentation de programmation (121) est utilisée comme extrémité de commande du circuit de programmation (120) et est couplée au point de couplage (140) avec la première électrode du premier transistor (112), la première électrode du deuxième transistor (132) et la première électrode du quatrième transistor (122), et une extrémité de sortie du circuit de commutation d'alimentation de programmation (121) est utilisée comme extrémité de sortie du circuit de programmation (120) et est configurée pour être couplée à la cellule de mémoire (210) afin de fournir la tension de programmation à la cellule de mémoire (210) ; et
la capacité de commande du quatrième transistor (122) est égale ou inférieure à la capacité de commande du premier transistor (112).

7. Circuit selon la revendication 6, dans lequel le circuit de commutation de puissance de programmation (121) comprend une quantité impaire de composants inverseur (1211) ;
un seul composant inverseur comprend un transistor NMOS et un transistor PMOS, une grille du transistor PMOS du composant inverseur (1211) et une grille du transistor NMOS du composant inverseur (1211) sont couplées puis utilisées comme extrémité de commande du composant inverseur (1211), un drain du transistor PMOS du composant inverseur (1211) et un drain du transistor NMOS du composant inverseur (1211) sont couplés puis utilisés comme extrémité de sortie du composant inverseur (1211), et une source du transistor PMOS du composant inverseur (1211) est connectée à la tension de programmation ; et
lorsque le circuit de commutation d'alimentation de programmation (121) comprend un composant inverseur unique, une extrémité de commande du composant inverseur unique est utilisée comme extrémité de commande du circuit de commutation de puissance de programmation (121) et est couplée au point de couplage (140) avec la première électrode du premier transistor (112), la première électrode du deuxième transistor (132) et la première électrode du quatrième transistor (122), et une extrémité de sortie du composant inverseur unique est utilisée comme extrémité de sortie du circuit de commutation de puissance de programmation (121) et est configurée pour être couplée à la cellule de mémoire (210) afin de fournir la tension de programmation à la cellule de mémoire (210) ; ou
lorsque le circuit de commutation d'alimentation de programmation (121) comprend une pluralité de composants inverseurs (1211), une extrémité de sortie d'un composant inverseur d'un stade précédent est couplé à une extrémité de commande du composant inverseur d'un stade suivant, une extrémité de commande d'un composant inverseur d'un premier stade est utilisé comme extrémité de commande du circuit de commutation de puissance de programmation (121) et est couplée au point de couplage (140) avec la première électrode du premier transistor (112), la première électrode du deuxième transistor (132) et la première électrode du quatrième transistor (122), et une extrémité de sortie d'un composant inverseur d'un dernier stade est utilisée comme extrémité de sortie du circuit de commutation de puissance de programmation (121) et est configurée pour être couplée à la cellule de mémoire (210) afin de fournir la tension de programmation à la cellule de mémoire (210) .

8. Circuit selon la revendication 6 ou 7, dans lequel une seconde électrode du quatrième transistor (122) est connectée à la tension de programmation.

9. Circuit selon la revendication 1, dans lequel le circuit de tension de commande (111) comprend un premier inverseur (1111), une grille NAND (1112) et un groupe d'inverseurs (1113), et le groupe d'inverseurs (1113) comprend un nombre impair de seconds inverseurs ; et
une extrémité d'entrée du premier inverseur (1111) est configurée pour recevoir un premier signal de commande, une extrémité de sortie du premier inverseur (1111) est couplée à une première extrémité d'entrée de la grille NAND (1112), une seconde extrémité d'entrée de la grille NAND (1112) est configurée pour être connectée à un second signal de commande, une extrémité de sortie de la grille NAND (1112) est connectée à une extrémité d'entrée du groupe d'inverseurs (1113), et une extrémité de sortie du groupe d'inverseurs (1113) est utilisée comme extrémité de sortie du circuit de tension de commande (111) et est couplée à la grille du premier transistor (112), et est configurée pour fournir une tension de commande.

10. Circuit selon l'une quelconque des revendications 1 à 9, dans lequel le circuit de commande (110) comprend en outre un cinquième transistor (114), une grille du cinquième transistor (114) est connectée en parallèle à la grille du premier transistor (112) et est configurée pour être couplée à l'extrémité de sortie du circuit de tension de commande (111), une première électrode du cinquième transistor (114) est couplée à la seconde électrode du troisième transistor (113) et une seconde électrode du cinquième transistor (114) est mise à la terre.

11. Circuit selon l'une quelconque des revendications 1 à 10, dans lequel une seconde électrode du deuxième transistor (132) est connectée à la tension de programmation.

12. Mémoire à fusible programmable électriquement, dans laquelle la mémoire à fusible programmable électriquement comprend le circuit de commutation de puissance (10, 201) selon l'une quelconque des revendications 1 à 11 et un réseau de cellules de mémoire (20) ; le circuit de commutation de puissance (10, 201) est configuré pour : recevoir un signal de commande et fournir, sur la base du signal de commande, la tension de programmation à une cellule de mémoire (210) dans le réseau de cellules de mémoire couplées.

13. Dispositif électronique (2), dans lequel le dispositif électronique (2) comprend le circuit de commutation de puissance (10, 201) selon l'une quelconque des revendications 1 à 11 ; le circuit de commutation de puissance (10, 201) est configuré pour recevoir un signal de commande et fournir, sur la base du signal de commande, la tension de programmation à une cellule de mémoire (210) dans un réseau de cellules de mémoire couplées.
